# EUROPÄISCHE PATENTANMELDUNG

(11) **EP 4 074 861 A1**
(43) Veröffentlichungstag der Anmeldung: **19.10.2022**
(21) Anmeldenummer: 21168168.9
(22) Anmeldetag: 13.04.2021
(51) Int. Cl.: C23C 16/44, C23C 16/455, C30B 25/14, C30B 29/06

(54) **VERFAHREN ZUM HERSTELLEN VON HALBLEITERSCHEIBEN MIT AUS DER GASPHASE ABGESCHIEDENER EPITAKTISCHER SCHICHT IN EINER ABSCHEIDEKAMMER**

(71) Anmelder: Siltronic AG, 81677 München (DE)
(72) Erfinder: Hengst, Ronny, 09618 Brand-Erbisdorf (DE)
(74) Vertreter: Staudacher, Wolfgang

(57) **Zusammenfassung**

Verfahren zum Herstellen von Halbleiterscheiben mit aus der Gasphase abgeschiedener epitaktischer Schicht in einer Abscheidekammer, umfassend das Entfernen von Material aus der Abscheidekammer, das sich im Verlauf vorangegangener Beschichtungsvorgänge in der Abscheidekammer niedergeschlagen hat, mittels einer Ätze der Abscheidekammer;
nacheinander durchgeführte Beschichtungsvorgänge, während derer jeweils eine epitaktische Schicht auf einer Substratscheibe in der Abscheidekammer abgeschieden wird, indem ein erster Gasstrom aus erstem Abscheidegas über die Substratscheibe geleitet wird und eine Halbleiterscheibe mit epitaktischer Schicht entsteht;
vor, während oder nach einem jeden der nacheinander durchgeführten Beschichtungsvorgänge das Leiten eines zweiten Gasstroms aus einem zweiten Abscheidegas zu einem Randbereich der jeweiligen Substratscheibe beziehungsweise der jeweiligen Halbleiterscheibe mit epitaktischer Schicht, wobei mindestens ein Verfahrensparameter geändert wird, der bewirkt, dass durch das Leiten des zweiten Abscheidegases eine Materialabscheidung im Randbereich in Abhängigkeit von der Zahl der seit dem Entfernen von Material aus der Abscheidekammer durchgeführten Beschichtungsvorgänge zunimmt.

## Beschreibung

Gegenstand der Erfindung ist ein Verfahren zum Herstellen von Halbleiterscheiben mit aus der Gasphase abgeschiedener epitaktischer Schicht in einer Abscheidekammer, umfassend das Entfernen von Material aus der Abscheidekammer, das sich im Verlauf vorangegangener Beschichtungsvorgänge in der Abscheidekammer niedergeschlagen hat.

### Stand der Technik / Probleme

Halbleiterscheiben mit aus der Gasphase abgeschiedener epitaktischer Schicht werden zur Herstellung elektronischer Bauelemente benötigt. Das Abscheiden der epitaktischen Schicht findet üblicherweise in einer Abscheidekammer statt, die als Einzelscheiben-Reaktor ausgebildet ist. Die zu beschichtende Substratscheibe wird auf einem Suszeptor abgelegt, und ein Abscheidegas bei einer Abscheidetemperatur durch die Abscheidekammer über die sich mit dem Suszeptor drehende Substratscheibe geleitet.

Es sind auch Abscheidekammern bekannt, die es ermöglichen, einen zweiten Gasstrom einzurichten, dessen Richtung abweicht von der Richtung des ersten Gasstroms, der hauptsächlich das Entstehen der epitaktischen Schicht bewirkt.

Gemäß US 2014 0 137 801 A1 kann eine solche Abscheidekammer verwendet werden, um einen zweiten Strom von Abscheidegas einzurichten.

In US 2015 0 368 796 A1 wird eine solche Abscheidekammer vorgeschlagen, um ein Ätzgas und ein Abscheidegas zur Reaktion zu bringen.

In JP 2019 114 699 A ist ein Verfahren beschrieben, das einen zweiten Gasstrom dazu einsetzt, die Wirkung des ersten Gasstroms zu beeinflussen.

WO 2017 102 597 A1 widmet sich insbesondere der Aufgabe, die Randgeometrie einer Halbleiterscheibe mit epitaktischer Schicht zu verbessern. Es wurde festgestellt, dass nach einer üblicherweise regelmäßig durchgeführten Ätze der Abscheidekammer (Kammerätze), um Material zu entfernen, das sich im Verlauf vorangegangener Beschichtungsvorgänge in der Abscheidekammer niedergeschlagen hat, ein Randabfall bei nachfolgend in der Abscheidekammer erzeugten Halbleiterscheiben mit epitaktischer Schicht von Beschichtungsvorgang zu Beschichtungsvorgang zunimmt. Es wird vorgeschlagen, vor dem Abscheiden der epitaktischen Schicht eine Ätze in Gegenwart der jeweiligen zu beschichtenden Substratscheibe durchzuführen, um damit eine geringer werdende Materialabscheidung im Randbereich während des Abscheidens der epitaktischen Schicht zu kompensieren, die den zunehmenden Randabfall zur Folge hat. Nachteilig an diesem Vorschlag ist, dass durch das Ätzen ein übermäßiger Materialabtrag bewirkt werden kann, Kristalldefekte in der Substratscheibe freigelegt werden können und Partikel erzeugt werden können, die die Halbleiterscheibe mit epitaktischer Schicht verunreinigen.

Aufgabe der vorliegenden Erfindung ist es, dem Phänomen des zunehmenden Randabfalls nach einer Kammerätze zu begegnen, ohne dass die erwähnten Nachteile in Kauf genommen werden müssen.

Die Aufgabe der Erfindung wird gelöst durch ein Verfahren zum Herstellen von Halbleiterscheiben mit aus der Gasphase abgeschiedener epitaktischer Schicht in einer Abscheidekammer, umfassend
das Entfernen von Material aus der Abscheidekammer, das sich im Verlauf vorangegangener Beschichtungsvorgänge in der Abscheidekammer niedergeschlagen hat, mittels einer Ätze der Abscheidekammer;
nacheinander durchgeführte Beschichtungsvorgänge, während derer jeweils eine epitaktische Schicht auf einer Substratscheibe in der Abscheidekammer abgeschieden wird, indem ein erster Gasstrom aus erstem Abscheidegas über die Substratscheibe geleitet wird und eine Halbleiterscheibe mit epitaktischer Schicht entsteht;
vor, während oder nach einem jeden der nacheinander durchgeführten Beschichtungsvorgänge das Leiten eines zweiten Gasstroms aus einem zweiten Abscheidegas zu einem Randbereich der jeweiligen Substratscheibe beziehungsweise der jeweiligen Halbleiterscheibe mit epitaktischer Schicht, wobei mindestens ein Verfahrensparameter geändert wird, der bewirkt, dass durch das Leiten des zweiten Abscheidegases eine Materialabscheidung im Randbereich in Abhängigkeit von der Zahl der seit dem Entfernen von Material aus der Abscheidekammer durchgeführten Beschichtungsvorgänge zunimmt.

Erfindungsgemäß wird ein zweiter Gasstrom aus zweitem Abscheidegas eingerichtet, der die zu erwartende, von Beschichtungsvorgang zu Beschichtungsvorgang geringer werdende Materialabscheidung im Randbereich möglichst ausgleicht, indem er eine von Beschichtungsvorgang zu Beschichtungsvorgang zunehmende Materialabscheidung im Randbereich bewirkt.

Die Materialabscheidung, die das zweite Abscheidegas bewirkt, kann vor, während oder nach dem Beschichtungsvorgang erfolgen, mit dem die epitaktische Schicht auf der Substratscheibe erzeugt wird. Da sich der erste und der zweite Gasstrom gegenseitig beeinflussen können, wird die Materialabscheidung mittels des zweiten Abscheidegases vorzugsweise vor dem Abscheiden der epitaktischen Schicht auf der Substratscheibe durchgeführt. Es ist aber auch möglich, die Materialabscheidung durch das zweite Abscheidegas auf der fertigen Halbleiterscheibe mit epitaktischer Schicht zu bewirken, also nach dem Abscheiden der epitaktischen Schicht durch das erste Abscheidegas. Obwohl eine Materialabscheidung durch das zweite Abscheidegas während des Abscheidens der epitaktischen Schicht nicht ausgeschlossen ist, sind damit Vorteile verbunden, wenn diese Materialabscheidung als eigenständiger Verfahrensschritt vor oder nach dem Abscheiden der epitaktischen Schicht durchgeführt wird. In diesen Fällen bleibt die Prozesskontrolle vollumfänglich und unabhängig voneinander sowohl für den Beschichtungsvorgang, der die epitaktische Schicht erzeugt, als auch für den Verfahrensschritt, der die Materialabscheidung im Randbereich bewirkt, erhalten. Im Folgenden wird stellvertretend für die Anwendung eines eigenständigen Verfahrensschritts davon ausgegangen, dass die Materialabscheidung durch das zweite Abscheidegas vor dem jeweiligen Beschichtungsvorgang erfolgt. Gegebenenfalls kann dieser eigenständige Verfahrensschritt auch umfassen, dass zusätzlich zum zweiten Gasstrom aus zweitem Abscheidegas ein erster Gasstrom aus Trägergas, beispielsweise Wasserstoff, vorgesehen wird, der über die Substratscheibe geleitet wird. Der jeweilige eigenständige Beschichtungsvorgang kann auch umfassen, dass zusätzlich zum ersten Gasstrom aus erstem Abscheidegas ein zweiter Gasstrom aus Trägergas vorgesehen wird, der zum Rand der Substratscheibe geleitet wird, um die Zuleitungen zu spülen. Die Volumengeschwindigkeit eines solchen zweiten Gasstroms aus Trägergas beträgt für diesen Fall vorzugsweise weniger als 5 slm, besonders bevorzugt weniger als 3 slm.

Der zweite Gasstrom aus zweitem Abscheidegas beziehungsweise aus Trägergas wird zum Randbereich der auf einem Suszeptor liegenden Substratscheibe geleitet. Der zweite Gasstrom hat dementsprechend eine Richtungskomponente, die senkrecht in Richtung des ersten Gasstroms aus erstem Abscheidegas beziehungsweise aus Trägergas gerichtet ist.

Das erste und das zweite Abscheidegas enthalten jeweils ein Precursor-Gas, das den Halbleiter enthält, der abgeschieden wird, beispielsweise ein Silan wie Trichlorsilan. Darüber hinaus können das erste Abscheidegas und das zweite Abscheidegas auch ein Trägergas, beispielsweise Wasserstoff, und gegebenenfalls ein Dotiergas, beispielsweise Diboran, enthalten. Diese Gase werden zum ersten beziehungsweise zum zweiten Gasstrom aus Abscheidegas vermischt. Das Dotiergas enthält einen Dotierstoff, der mit dem Halbleitermaterial abgeschieden wird. Die Zusammensetzung des ersten und des zweiten Abscheidegases kann identisch sein oder sich unterscheiden.

Die Verfahrensbedingungen, unter denen das zweite Abscheidegas während des Verfahrensschritts zur Substratscheibe geleitet wird, unterscheiden sich voneinander und zwar in Abhängigkeit von der Anzahl an Beschichtungsvorgängen mit dem ersten Abscheidegas, die seit der letzten Kammerätze durchgeführt wurden. Je größer diese Anzahl ist, desto mehr Material wird im Randbereich der Substratscheibe durch das zweite Abscheidegas abgeschieden. Die Verfahrensbedingungen werden derart eingestellt, dass die Dicke des im Randbereich abgeschiedenen Materials den Randabfall möglichst kompensiert, der ohne den Verfahrensschritt nach dem anschließenden Beschichtungsvorgang zu erwarten wäre.

Da der zu erwartende Randabfall von Beschichtungsvorgang zu Beschichtungsvorgang zunimmt, wird für den Verfahrensschritt mindestens ein Verfahrensparameter geändert, der bewirkt, dass im Vergleich zum vorhergehenden Verfahrensschritt der zu erwartenden Zunahme des Randabfalls entsprechend mehr Material im Randbereich der Substratscheibe abgeschieden wird. Geeignete Verfahrensparameter sind beispielsweise die Dauer, während derer das zweite Abscheidegas zum Randbereich der Substratscheibe geleitet wird, oder die Geschwindigkeit, mit der der zweite Gasstrom aus zweitem Abscheidegas zum Randbereich der Substratscheibe geleitet wird. Je länger beispielsweise das zweite Abscheidegas zum Randbereich der Substratscheibe geleitet wird, umso mehr an Material wird dort abgeschieden werden. Als Verfahrensparameter geeignet ist auch das Volumen-Verhältnis von Precursor-Gas und Trägergas im zweiten Gasstrom aus Abscheidegas, das Verhältnis der Volumen-Geschwindigkeiten von Precursor-Gas und Trägergas vor dem Vermischen dieser Gase zum Bilden des zweiten Gasstroms aus Abscheidegas, die Temperatur in der Abscheidekammer oder die Geschwindigkeit, mit der die Substratscheibe gedreht wird. Eine optimale Abstimmung der Verfahrensparameter im Sinne der vorliegenden Erfindung hängt auch von der verwendeten Abscheidekammer ab und gegebenenfalls von der Volumengeschwindigkeit des Trägergases, falls es als erster Gasstrom aus Trägergas zusätzlich zum zweiten Gasstrom aus Abscheidegas während eines eigenständigen Verfahrensschritts eingesetzt wird. Diese Abstimmung kann an Hand von Versuchen herausgefunden werden.

Zum Entfernen von Material aus der Abscheidekammer, das sich im Verlauf vorangegangener Beschichtungsvorgänge in der Abscheidekammer niedergeschlagen hat, wird ein Ätzgas, beispielsweise Chlorwasserstoff durch die Abscheidekammer geleitet. Eine solche Kammerätze wird vorzugsweise regelmäßig durchgeführt, beispielsweise dann, wenn ein Materialniederschlag auf einer inneren Oberfläche der Abscheidekammer eine vorgegebene Dicke erreicht oder überschritten hat oder nachdem eine vorgegebene Zahl an Beschichtungsvorgängen durchgeführt wurde. Nach der Kammerätze kann eine Kammerbeschichtung (coating) durchgeführt werden, beispielsweise indem Trichlorsilan bei Abscheidetemperatur durch die Abscheidekammer geleitet wird. Das kann auch in Gegenwart einer auf dem Suszeptor liegenden Substratscheibe erfolgen, die als Platzhalter (dummy) den Suszeptor abdeckt.

Die Erfindung wird nachfolgend unter Bezugnahme auf Zeichnungen weiter beschrieben.

### Kurzbeschreibung der Figuren

Fig. 1 zeigt Komponenten einer Abscheidekammer, die zur Durchführung des erfindungsgemäßen Verfahrens geeignet ist.
**Fig. 2** zeigt in Draufsicht das Leiten eines ersten und eines zweiten Gasstroms zur Substratscheibe.
**Fig. 3** **und** **Fig. 4** zeigen die Veränderung der Randgeometrie in Abhängigkeit der Reihenfolge des Abscheidens der epitaktischen Schicht nach einer Kammerätze.

### Liste der verwendeten Bezugszeichen

- 1: oberer Deckel
- **2**: unterer Deckel
- **3**: Abscheidekammer
- **4**: Substratscheibe
- **5**: Suszeptor
- **6**: Vorheizring
- **7**: obere Auskleidung
- **8**: untere Auskleidung
- **9**: erste Gaseintrittsöffnungen
- **10**: Gaseintrittsöffnung für den zweiten Gasstrom
- **11**: erster Gasauslass
- **12**: untere Gaseintrittsöffnungen
- **13**: unterer Gasauslass
- **14**: erster Gasstrom
- **15**: zweiter Gasstrom

### Detaillierte Beschreibung erfindungsgemäßer Ausführungsbeispiele

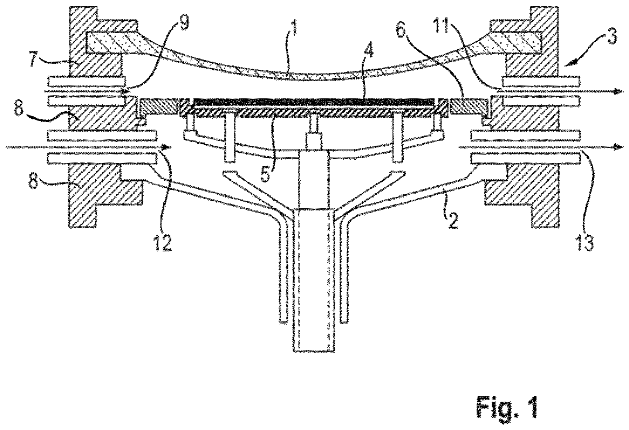

Die in Fig.1 dargestellte Vorrichtung zum Abscheiden einer epitaktischen Schicht auf einer Substratscheibe umfasst eine Abscheidekammer 3 mit einem oberen Deckel 1 und einem unteren Deckel 2 und obere und untere Auskleidungen 7 und 8, die einen Reaktionsraum umschließen. Außerhalb der Abscheidekammer 3 vorhandene obere und untere Lampenbänke sind nicht dargestellt. Mittels der Strahlungsenergie der Lampen wird die Abscheidekammer auf die Temperatur gebracht, die für die Gasphasenabscheidung notwendig ist.

Für einen Beschichtungsvorgang wird eine Substratscheibe 4 auf einem Suszeptor 5 abgelegt, der von unten durch Arme eines Trägers drehbar gehalten wird. Um den Suszeptor herum ist ein Vorheizring 6 angeordnet. Die Substratscheibe 4 kann mittels Hebestiften, die durch den Suszeptor 5 durchgeführt sind, auf dem Suszeptor 5 abgelegt und nach dem Beschichten vom Suszeptor 5 weggehoben werden.

Beim Beschichten der Substratscheibe 4 wird das erste Abscheidegas durch erste Gaseintrittsöffnungen 9, die in der oberen Auskleidung 7 vorgesehen sind, in die Abscheidekammer 3 entlang einer ersten Strömungsrichtung über die Substratscheibe zu einem ersten Gasauslass 11 gleitet. Darüber hinaus sind eine oder mehrere zweite Gaseintrittsöffnungen in der unteren Auskleidung vorgesehen, durch die während eines eigenständigen Verfahrensschritts oder während eines Beschichtungsvorgangs Abscheidegas entlang einer zweiten Strömungsrichtung zum Randbereich der Substratscheibe 4 beziehungsweise einer Halbleiterscheibe mit epitaktischer Schicht geleitet wird. Schließlich können optional untere Gaseintrittsöffnungen 12 und ein unterer Gasauslass 13 vorgesehen sein, um ein Spülgas unter dem Suszeptor 5 hindurch zum unteren Gasauslass 13 zu leiten.

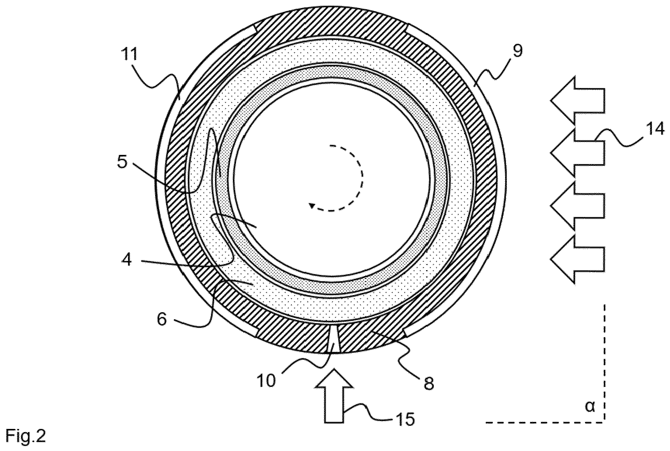

Fig. 2 zeigt in Draufsicht das Leiten eines ersten Gasstroms 14 über die Substratscheibe 4 und eines zweiten Gasstroms 15 zum Randbereich der Substratscheibe 4. Der zweite Gasstrom 15 hat eine Richtungskomponente senkrecht zur Strömungsrichtung des ersten Gasstroms 14. Die beiden Strömungsrichtungen schließen einen Winkel α ein, der vorzugsweise 45° bis 90° beträgt. Ist das Zuleiten eines Abscheidegases über den zweiten Gasstrom 15 in Form eines eigenständigen Verfahrensschritts vorgesehen, wird vorzugsweise gleichzeitig ein erster Gasstrom 14, der aus einem Trägergas besteht, über die Substratscheibe 4 oder eine Halbleiterscheibe mit epitaktischer Schicht geleitet. Während eines Beschichtungsvorgangs, der vor oder nach dem eigenständigen Verfahrensschritt durchgeführt wird, wird Abscheidegas nur über den ersten Gasstrom 14 über die Substratscheibe geleitet und gegebenenfalls Trägergas über den zweiten Gasstrom 15 zum Rand der Substratscheibe. Wird auf einen eigenständigen Verfahrensschritt verzichtet, enthalten sowohl der erste Gasstrom 14 als auch der zweite Gasstrom 15 Abscheidegas.

### Beispiel:

In einem ersten Versuch wurde auf 25 Substratscheiben aus einkristallinem Silizium und mit einem Durchmesser von 300 mm jeweils eine epitaktische Schicht aus einkristallinem Silizium abgeschieden. Die Beschichtungsvorgänge wurden in der Abscheidekammer eines Einzelscheiben-Reaktors nach einer Kammerätze der Abscheidekammer durchgeführt. Der Einzelscheiben-Reaktor war derart ausgebildet, dass ein erster Gasstrom über die Substratscheibe und ein zweiter Gasstrom zum Randbereich der Substratscheibe geleitet werden konnte.

Bei jeder zweiten Substratscheibe wurde vor dem Beschichtungsvorgang ein eigenständiger Verfahrensschritt durchgeführt, währenddessen ein erster Gasstrom aus Trägergas über die Substratscheibe und ein zweiter Gasstrom aus Abscheidegas zum Randbereich der Substratscheibe geleitet wurde. Die Dauer des Zuführens des zweiten Gasstroms aus Abscheidegas wurde umso länger gewählt, je mehr Beschichtungsvorgänge seit der Kammerätze durchgeführt worden waren. Vor Beschichtungsvorgängen mit gerader laufender Nummer wurde auf den separaten Verfahrensschritt vor dem Beschichtungsvorgang verzichtet.

Nach dem folgenden Beschichtungsvorgang wurde die Randgeometrie der erzeugten Halbleiterscheiben mit epitaktischer Schicht untersucht und in Form des ESFQD_AVG_Δ (Edge Site Front surface least sQuares site Deviation, ESFQD) quantifiziert. ESFQD-Messwerte von 72 Edge Sites (Sektoren mit einer Länge von 30 mm bei einem Randausschluss von 2 mm, die Messwerte ermittelt auf einer Fläche der Sektoren mit einer Länge zwischen Radius 147,5 mm und 148 mm) und zu jeweils einem Mittelwert (AVG) für jede Substratscheibe und jede resultierende Halbleiterscheibe mit epitaktischer Schicht berechnet und das Paar der beiden Mittelwerte voneinander subtrahiert (Δ).

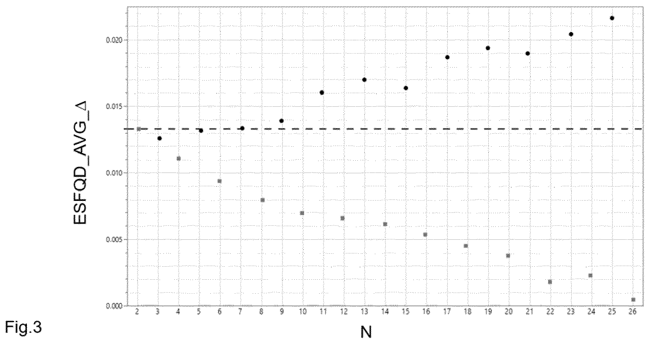

In Fig.3 ist ESFQD_AVG_Δ als Ergebnis der Subtraktion in Abhängigkeit der Reihenfolge N an durchgeführten Beschichtungsvorgängen seit der Kammerätze aufgetragen. Dabei sind ungerade Zahlen der Reihenfolge solchen Substratscheiben zugeordnet, die erfindungsgemäß beschichtet wurden, gerade Zahlen solchen Substratscheiben, die ohne den separaten Verfahrensschritt, also in Abwesenheit eines zweiten Gasstroms aus Abscheidegas beschichtet wurden. Darüber hinaus dauerte im Fall eines erfindungsgemäß durchgeführten Verfahrens die Dauer des Leitens des zweiten Gasstroms aus Abscheidegas zum Randbereich der Substratscheibe um einen jeweils gleichbleibenden Betrag länger als die entsprechende Dauer während des unmittelbar davor erfindungsgemäß durchgeführten Verfahrens.

Die mit gerader Reihenfolge abfallenden Datenpunkte spiegeln den Effekt des zunehmenden Randabfalls nach einer Kammerätze wider, wenn nicht eingegriffen wird. Die ansteigenden Datenpunkte mit ungerader Zahl der Reihenfolge zeigen, dass der erfindungsgemäße Eingriff den Randabfall teilweise mehr als kompensiert hatte und sogar mehr als beabsichtigt an Material im Randbereich abgeschieden wurde.

In einem weiteren Versuch wurde für erfindungsgemäß durchgeführte Beschichtungsvorgänge mit ungerader Zahl der Reihenfolge auf den eigenständigen Verfahrensschritt verzichtet, also der zweite Gasstrom aus zweitem Abscheidegas während des Beschichtungsvorgangs zum Randbereich der Substratscheibe geleitet, ein anderes Verhältnis der Volumen-Geschwindigkeiten von Precursor-Gas und Trägergas gewählt, bevor diese zur Bildung des zweiten Gasstroms aus Abscheidegas vermischt wurden und die Dauer des Beschichtungsvorgangs im Vergleich mit dessen Dauer im ersten Versuch verkürzt.

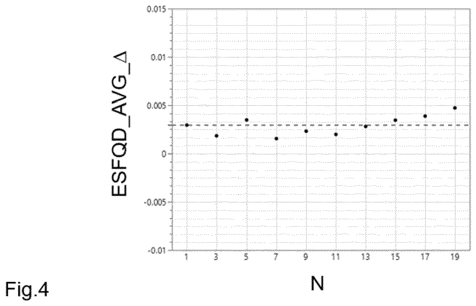

Fig.4 zeigt, dass mit der gewählten Kombination von Verfahrensparametern eine vergleichsweise einheitliche Randgeometrie der Halbleiterscheiben mit epitaktischer Schicht erzielt werden konnte.

## Patentansprüche

1. Verfahren zum Herstellen von Halbleiterscheiben mit aus der Gasphase abgeschiedener epitaktischer Schicht in einer Abscheidekammer, umfassend das Entfernen von Material aus der Abscheidekammer, das sich im Verlauf vorangegangener Beschichtungsvorgänge in der Abscheidekammer niedergeschlagen hat, mittels einer Ätze der Abscheidekammer;
nacheinander durchgeführte Beschichtungsvorgänge, während derer jeweils eine epitaktische Schicht auf einer Substratscheibe in der Abscheidekammer abgeschieden wird, indem ein erster Gasstrom aus erstem Abscheidegas über die Substratscheibe geleitet wird und eine Halbleiterscheibe mit epitaktischer Schicht entsteht;
vor, während oder nach einem jeden der nacheinander durchgeführten Beschichtungsvorgänge das Leiten eines zweiten Gasstroms aus einem zweiten Abscheidegas zu einem Randbereich der jeweiligen Substratscheibe beziehungsweise der jeweiligen Halbleiterscheibe mit epitaktischer Schicht, wobei mindestens ein Verfahrensparameter geändert wird, der bewirkt, dass durch das Leiten des zweiten Abscheidegases eine Materialabscheidung im Randbereich in Abhängigkeit von der Zahl der seit dem Entfernen von Material aus der Abscheidekammer durchgeführten Beschichtungsvorgänge zunimmt.

2. Verfahren nach Anspruch 1, **dadurch gekennzeichnet, dass** der mindestens eine Verfahrensparameter aus einer Gruppe ausgewählt wird, die die Dauer, während derer der zweite Gasstrom aus zweitem Abscheidegas zur Substratscheibe geleitet wird, die Geschwindigkeit, mit der das zweite Abscheidegas zum Randbereich der Substratscheibe geleitet wird, das Volumen-Verhältnis eines Precursor-Gases und eines Trägergases im zweiten Gasstrom, das Verhältnis der Volumen-Geschwindigkeiten des Precursor-Gases und des Trägergases vor dem Vermischen dieser Gase zur Bildung des zweiten Gasstroms, die Temperatur in der Abscheidekammer und die Geschwindigkeit, mit der die Substratscheibe gedreht wird, umfasst.
